# EUROPÄISCHE PATENTSCHRIFT

(11) **EP 2 157 437 B1**
(45) Veröffentlichungstag und Bekanntmachung des Hinweises auf die Patenterteilung: **19.08.2015**
(21) Anmeldenummer: 08014666.5
(22) Anmeldetag: 19.08.2008
(51) Int. Cl.: G01R 31/40

(54) **Verfahren zur Messung eines Stroms, insbesondere durch eine Erdungsvorrichtung**
Method for measuring a current, particularly through an earthing device
Procédé de mesure d'un courant, en particulier par un dispositif de mise à la terre

(43) Veröffentlichungstag der Anmeldung: 24.02.2010
(73) Patentinhaber: SMA Solar Technology AG, 34266 Niestetal (DE)
(72) Erfinder: Müller, Burkard, Dipl.-Ing., 34123 Kassel (DE)
(74) Vertreter: Lahnor, Peter

(56) Entgegenhaltungen:
- EP-A- 1 857 825
- WO-A-03/052433
- DE-A1- 19 844 465
- FR-A- 2 856 856
- GB-A- 2 272 300
- JP-A- 11 160 368
- JP-A- 56 006 508
- US-A- 5 498 984

## Beschreibung

Die Erfindung betrifft eine Schaltungsanordnung mit den Merkmalen des Oberbegriffs des unabhängigen Patentanspruchs 1. Diese Schaltungsanordnung kann insbesondere zur Messung des Stroms durch ein Erdschluss-Sicherungselement und/oder Erdungsanschlusselement einer Erdungsvorrichtung eines Wechselrichters benutzt werden, der die Leistung einer Gleichspannungsquelle in ein Wechselspannungsnetz einspeisen soll.

Zur Strommessung sind sogenannte Shuntwiderstände bekannt, die eng tolerierte und temperaturstabile Widerstandswerte aufweisen. Diese werden vom Messstrom durchflossen, wodurch am Widerstand eine Spannung gemessen werden kann, die proportional zum Strom ist. Diese Spannung kann über einen Verstärker der Auswerteeinheit, z.B. einem Mikrocontroller zugeführt werden. Um die ohmschen Verluste im Shuntwiderstand klein zu halten, wird der Widerstandswert von Shuntwiderständen sehr klein, insbesondere unter 1 Ohm gehalten. Die Spannung am Shuntwiderstand ist dadurch ebenfalls klein, z.B. einige mV. Diese geringe Messspannung wird zum Problem, wenn die Strommessung auf einem Potenzial erfolgt, das sich deutlich, z.B. um mehr als 50V, von dem der Auswerteeinheit unterscheidet. Einfache Differenzverstärker weisen dann einen Gleichtaktfehler auf, der die Messspannung stark verfälschen würde. Folglich müssen teure Spezialbauteile, z.B. sogenannte Instrumentenverstärker, eingesetzt werden.

Auf Instrumentenverstärker kann verzichtet werden, wenn der Messstrom nicht direkt durch den Shuntwiderstand fließt, sondern über einen Stromtransformator, so dass der Shunt auf das Potenzial der Auswerteeinheit gelegt werden kann. Diese Lösung ist jedoch nur für reine Wechselströme möglich.

Sollen auch Gleichströme gemessen werden, werden häufig Stromwandler eingesetzt, die das durch den Messstrom hervorgerufene Magnetfeld auswerten, z.B. mit einem Hall-Sensor. Solche Stromwandler sind sehr teuer.

Bekannt ist es, einen dem Messstrom proportionalen Strom von der Messstelle zur Auswertestelle zum Beispiel zum Prozessor fließen zu lassen. Es sind integrierte Schaltungen zur Strommessung erhältlich, die nach diesem Prinzip arbeiten. Diese können aber im allgemeinen nur eine Stromrichtung messen, so dass zur Messung von Strömen mit unbekanntem Vorzeichen zwei ICs erforderlich sind. Diese Messelektronik benötigt zudem eine Stromversorgung auf dem Potential der Messstelle, das jedoch erheblich vom Potential an der Auswertestelle abweichen kann. Eine Messung ist daher schwierig.

Bei Photovoltaikwechselrichtern in Photovoltaikanlagen mit Photovoltaikgeneratoren kann im Fehlerfall ein zusätzlicher Erdschluss erfolgten. Bei diesem Erdschluss fließt ein Strom durch die Erdungsvorrichtung. Dieser Strom muss erkannt werden, damit der Erdschluss behoben werden kann.

Ein bekanntes Verfahren besteht darin, den Strom über einen Stromwandler zu messen. Diese Wandler sind jedoch teuer. Außerdem weisen sie einen relativ hohen Offset auf, der zu Messproblemen führt.

Bei Photovoltaikanlagen besteht zudem das Problem, dass der Generator z.B. am Pluspol geerdet sein kann, während Prozessor bzw. Betriebsführungssystem (BFS) des Wechselrichters mit dem Minuspol des Generators verbunden sind. Dadurch kann das Potential der Auswertestelle erheblich, zum Beispiel um einige 100 Volt, vom Potential der Stelle abweichen, an der der Erdungsstrom gemessen wird.

Ein weitere Schwierigkeit besteht darin, dass es unterschiedliche Photovoltaik-Module gibt, die für einen optimalen Betrieb unterschiedliche Erdungsvarianten erfordern. So wird bei einigen handelsüblichen Modulen empfohlen, den Generator am Pluspol zu erden, während bei anderen eine Erdung des Generators am Minuspol vorgesehen ist. Ein zu messender Strom kann somit an zwei verschiedenen Stellen einer Anlage fließen. Dieses Problem hat man bisher dadurch gelöst, dass für jede Stelle ein separater Messkanal beispielsweise eines Mikroprozessors vorgesehen ist. Es ist somit erforderlich ständig mehrere Kanäle abzufragen, wenn nicht bekannt ist, an welcher Stelle ein Strom fließt.

Bekannt ist es auch, bei ungeerdeten Photovoltaikanlagen einen Isolationswiderstand Rᵢₛₒ zu messen. Ein solches Verfahren ist beispielsweise aus der DE 10 2006 022 686 A1 bzw. EP 1 857 825 A bekannt.

Die EP 1 857 825 A beschreibt eine Messanordnung für eine Photovoltaikanlage mit einem Wechselrichter. Zur Bestimmung eines Isolationswiderstands Riso werden zwei Widerstände Rs und zwei Schalter verwendet. Wenn einer der Schalter geschlossen ist, wird die Spannung über dem jeweiligen Widerstand Rs gemessen. Durch Isolationswiderstand Rist fließt ein Erdungsstrom. Um sowohl Isolationsfehler zwischen Pluspol und Erde als auch zwischen Minuspol und Erde, die gleichzeitig auftreten können, zu messen, wird an verschiedenen Stellen jeweils ein Widerstand, d. h. insgesamt zwei Widerstände, eingesetzt.

Bekannt ist weiterhin das Prinzip der Stromspiegelschaltung.

Aus der FR 2 856 856 A ist eine Stromspiegelschaltung bekannt, die in einem Messverfahren für ein Batterieladegerät Anwendung findet.

Die GB 2 272 300 A lehrt, einen einzigen Shunt mit einer zwei Transistoren umfassenden Stromspiegelschaltung einzusetzen. Diese Schaltung dient dazu, einen kleinen Spannungsabfall bei viel höherer Versorgungsspannung messen zu können.

Aus der WO 03/052433 A2 ist eine weitere Stromspiegelschaltung bekannt, die ebenfalls mit einem einzigen Shunt versehen ist. Die Schaltung weist ein Offseteinstellmittel zur Vorgabe eines Offsets der Ausgangsspannung auf.

Eine weitere Stromspiegelschaltung ist in der US 5,498,984 A offenbart. Diese weist einen Operationsverstärker und einen Shunt auf. Hier soll ein Stromfluss in beiden Richtungen durch den Shunt möglich sein und erkannt werden.

Eine weitere Stromspiegelschaltung ist aus der DE 198 44 465 A2 bekannt. Dort wird definiert, dass eine Stromspiegelschaltung aus einem Referenzzweig mit einem Halbleiter und einem Spiegelzweig besteht.

Die JP 11160368 offenbart ebenfalls eine Stromspiegelschaltung mit Halbleitern.

Eine Stromspiegelschaltung mit zwei gegeneinander geschalteten Stromspiegeln ist aus der JP 56006508 bekannt. Sie dient zur Messung eines Erdungsfehlers bei einem Verstärker. Die beiden Stromspiegel sind zu einer Kompensationsschaltung geschaltet, um einen Hin- und einen Rückstrom miteinander zu vergleichen, die jeweils durch einen Shuntwiderstand fließen, wobei sich die durch die Spannungen über den Shuntwiderständen hervorgerufenen Asymmetrien bei den beiden Stromspiegeln gerade aufheben, soweit Hin- und Rückstrom gleich groß sind. So tritt ein Signal nur dann auf, wenn ein Differenzstrom zwischen dem Hin- und Rückstrom auftritt, der ein Hinweis auf einen Strom nach Erde ist.

Der Erfindung liegt die Aufgabe zugrunde, eine einfache und kostengünstige Messung eines Stroms zu ermöglichen, auch wenn die Messstelle auf einem Potenzial liegt, das deutlich vom Potenzial der Auswertestelle abweicht. Insbesondere soll ein Verfahren der genannten Art gefunden werden, mit dem ein Erdungsstrom bei Photovoltaikanlagen mit wenig Aufwand messbar ist.

Diese Aufgabe wird durch eine Schaltungsanordnung mit den Merkmalen des unabhängigen Patentanspruchs 1 bzw. des unabhängigen Patentanspruchs 4 gelöst.

Gemäß Patentanspruch 1 werden Transistoren eingesetzt, deren Ernitteranschlüsse jeweils direkt oder über gleiche Widerstände mit den Anschlüssen des

Shunts verbunden werden. Da die Basisanschlüsse - wie bei Stromspiegeln üblich - miteinander verbunden sind, führt ein Spannungsabfall am Shunt unmittelbar zu unterschiedlichen Spannungen an den Basis-Emitter-Strecken bzw. an den Emitterwiderständen und damit zu einer Unsymmetrie im Stromspiegel.

Die Erfindung beruht auf der Erkenntnis, dass das an sich bekannte Prinzip des Stromspiegels für eine Strommessung auf einem Potenzial, das vom Potenzial der Auswerteeinheit deutlich abweicht, ideal ist und überraschende Vorteile bietet. Damit ist es insbesondere auch für die Erdungsstrommessung bei Photovoltaikanlagen gut geeignet.

Durch die Erfindung ist eine einfache Messung eines Stroms in zwei Richtungen auf einem Potential, das deutlich von dem der Auswertestelle abweicht, möglich, und zwar ohne dass eine Betriebsspannung auf dem Potential der Messstelle zur Verfügung gestellt werden muss.

Zudem kann mit der Erfindung ein Strom gemessen werden, der alternativ an zwei Stellen fließen kann, ohne dass ein Messkanal einer Auswerteeinrichtung umgeschaltet werden muss. Dies ist sehr vorteilhaft, wenn eine Photovoltaikanlage mit wahlweiser Erdung auf einem positiven Pol oder negativen Pol ausgestattet ist. Möglich wird dies, indem zwei der beschriebenen Anordnungen aus Stromspiegel und Shunt gegeneinander geschaltet, d.h. an den Kollektoranschlüssen der Transistoren miteinander verbunden werden und das Messsignal an dieser Stelle abgegriffen wird.

Durch eine Weiterbildung der Erfindung ist es möglich, dass mit geringem Aufwand der Isolationszustand einer elektrischen Anlage oder eines Gerätes bestimmt werden kann. Es kann also einerseits bei geerdeten Anlagen oder Geräten der Strom über die Erdungseinrichtung, beispielsweise einer Sicherung, gemessen werden und andererseits der Isolationswiderstand bei ungeerdeten Anlagen oder Geräten ermittelt werden. Dazu wird die erfindungsgemäße Schaltung so erweitert, dass sie eine Messung nach dem Prinzip der DE 10 2006 022 686 A1 ermöglicht.

Es wird einer der Shuntwiderstände benutzt, der vom Messstrom durchflossen wird. Der Spannungsabfall am Shunt verstimmt den Stromspiegel, beispielsweise mit Emitterwiderständen, so dass dieser eine Unsymmetrie aufweist. Diese Unsymmetrie ist proportional zum Messstrom und kann auf dem Potential einer Auswerteeinheit, insbesondere der Betriebsführung eines Wechselrichters, ausgewertet werden, beispielsweise mit einer Operationsverstärkerschaltung. Da beide Transistoren vorgespannt sind, kann der Spannungsabfall am Shunt deutlich kleiner sein als die Basis-Emitter-Spannung der Transistoren. Da Temperaturveränderungen auf beide Transistoren gleich wirken, weil diese vorzugsweise thermisch gekoppelt sind, bleibt die Unsymmetrie erhalten, so dass die Schaltung sehr temperaturstabil ist.

Um einen Strom alternativ auf zwei verschiedenen Potentialen zu messen, werden zwei Stromspiegel-Schaltungen kombiniert, indem beide Stromspiegel gegeneinander geschaltet werden. Die Auswertung kann zum Beispiel über eine Operationsverstärkerschaltung erfolgen, wenn die Unsymmetrie über zwei Transistoren mit antiparalleler Basis-Emitter-Strecke ausgekoppelt wird.

Bei Geräten bzw. Anlagen, die wahlweise geerdet wie auch ungeerdet betrieben werden können, kann eine Weiterbildung der eingesetzten Schaltung mit den zwei Shunts entweder zur Erdstrommessung oder zur Isolationsmessung benutzt werden. Mit Vorteil kann der Stromspiegels als Stromquelle für die Isolationsmessung bzw. Messung des Widerstandes Rᵢₛₒ benutzt werden.

Die Erfindung beruht auf den Gedanken, eine Messanordnung zur Bestimmung eines Stroms zu schaffen, der auf einem Potential fließt, das vom Potential der Auswertestelle stark, z.B. um mehr als 50 Volt abweicht, wobei der Messstrom über den Shunt geführt wird, dessen beide Anschlüsse jeweils direkt oder über gleiche Widerstände mit dem Emitter-bzw. Sourceanschluss zweier Transistoren verbunden sind, wobei die beiden Basis- bzw. Gateanschlüsse miteinander verbunden und an geeigneter Vorspannung angeschlossen sind, so dass die Differenz der beiden Kollektor- bzw. Drainströme auf dem Potential der Auswerteeinheit ermittelt wird.

Besonders vorteilhaft ist es, dass die Messanordnung mit geringem Mehraufwand auch zur Ermittlung eines Isolationswiderstands einer Stromerzeugungsanlage oder eines damit verbindbaren Geräts, insbesondere des Wechselrichters, eingesetzt werden kann. Durch eine solche Messung können Isolationsfehler rechtzeitig erkannt werden.

Optimal wird die Erfindung eingesetzt, wenn das Potential der Messstelle von dem Potential der Auswertestelle verschieden ist. In der Praxis können einige 100 Volt Abweichung vorhanden sein, z.B. wenn ein Erdungsstrom am Pluspol eines Photovoltaikgenerators gemessen wird, die Auswerteelektronik jedoch einen Potentialbezug zum Minuspol des Generators besitzt. Günstig ist die Erfindung bereits, wenn das Potential der Messstelle von einem Potential der Auswertestelle um mindestens 50 Volt abweicht.

Für die Erfindung wird das Prinzip des Stromspiegels ausgenutzt. Der Kollektor- bzw. Drainstrom zweier Transistoren ist nämlich gleich, wenn ihre Basis- bzw. Gateanschlüsse verbunden sind und die Emitter- bzw. Sourceanschlüsse direkt oder über gleiche Widerstände mit Masse verbunden werden und die beiden Transistoren thermisch gekoppelt sind. Ein derartiges Prinzip hat sich zum Beispiel bei einer Gleichtaktunterdrückung bei Operationsverstärkern bewährt.

Für die Strommessung wird zweckmäßigerweise ein Shunt in den Stromspiegel eingefügt, d.h. es werden beide Anschlüsse des Shunts über jeweils einen gleichen Widerstand mit einen Emitter- oder Sourceanschluss eines Transistors verbunden, wobei beide Basis- oder Gateanschlüsse der Transistoren miteinander verbunden und an eine Vorspannung angeschlossen sind, wobei eine Differenz der Kollektor- oder Drainströme ermittelt wird.

Vorteilhaft ist es, dass erfindungsgemäß die Differenz der Kollektor- oder Drainströme auf dem Potential einer Auswerteeinheit ermittelt wird. Z.B. kann bei einem am Pluspol geerdeten Photovoltaik-Generator der Erdungsstrom ermittelt werden, indem ein Shunt mit der beschriebenen Messeinrichtung in die Plusleitung eingefügt wird, die Kollektor- bzw. Drainanschlüsse jedoch über Widerstände mit der Minusleitung verbunden werden. Wird der Wert dieser Widerstände so gewählt, dass die Kollektor- bzw. Drainströme in ihnen Spannungen einprägen, die wesentlich kleiner sind als die Generatorspannung, und vielmehr im Messbereich einerAuswerteeinheit wie z.B. eines Mikroprozessors liegen, so ist die Messinformation auf elegante Art von einem Potenzial auf ein anderes übertragen worden, ohne dass es dazu eines magnetischen Stromwandlers, eines Optokopplers o.ä. bedurft hätte.

Wenn der Messstrom ein Erdungsstrom einer Photovoltaikanlage mit wahlweiser Erdung eines positiven oder negativen Pols ist, kann vorteilhaft die Erfindung mit den zwei gegeneinander geschalteten Stromspiegeln benutzt werden, bei der der Messstrom alternativ an zwei verschiedenen Stellen fließen kann.

Durch eine Auswertung über einen Operationsverstärker kann eine hohe Messernpfindlichkeit erreicht werden, so dass sehr kleine Erdschlüssströme messbar sind.

Weitere vorteilhafte Ausgestaltungen der Erfindung sind in den Unteransprüchen gekennzeichnet.

Ein Ausführungsbeispiel wird anhand der Zeichnungen näher erläutert, wobei weitere vorteilhafte Weiterbildungen der Erfindung und Vorteile derselben beschrieben sind.

Es zeigen:
- Fig. 1: eine Phötovoltaikanlage;
- Fig. 2a: eine Schaltung nach dem Prinzip eines Stromspiegels,
- Fig. 2b: die Schaltung nach Fig. 2a jedoch mit Emitterwiderständen,
- Fig. 3: eine Operationsverstärkerschaltung mit einem Messshunt,
- Fig. 4a: eine Schaltung zur Strommessung
- Fig. 4b: eine Erweiterung der Schaltung nach Fig. 4a mit einer Operationsverstärkerschaltung,
- Fig. 5a: eine Schaltung nach Fig. 4a, jedoch zur alternativen Messung zweier Ströme I1 oder I2, die auf zwei verschiedenen Potentialen fließen,
- Fig. 5b: eine Erweiterung der Schaltung nach Fig. 5a mit einer Operationsverstärkerschaltung und
- Fig. 6: eine Erweiterung der Schaltung nach Fig. 5b zum Einsatz in einer Photovoltaikanlage mit zusätzlicher Messmöglichkeit eines Isolationswiderstandes.

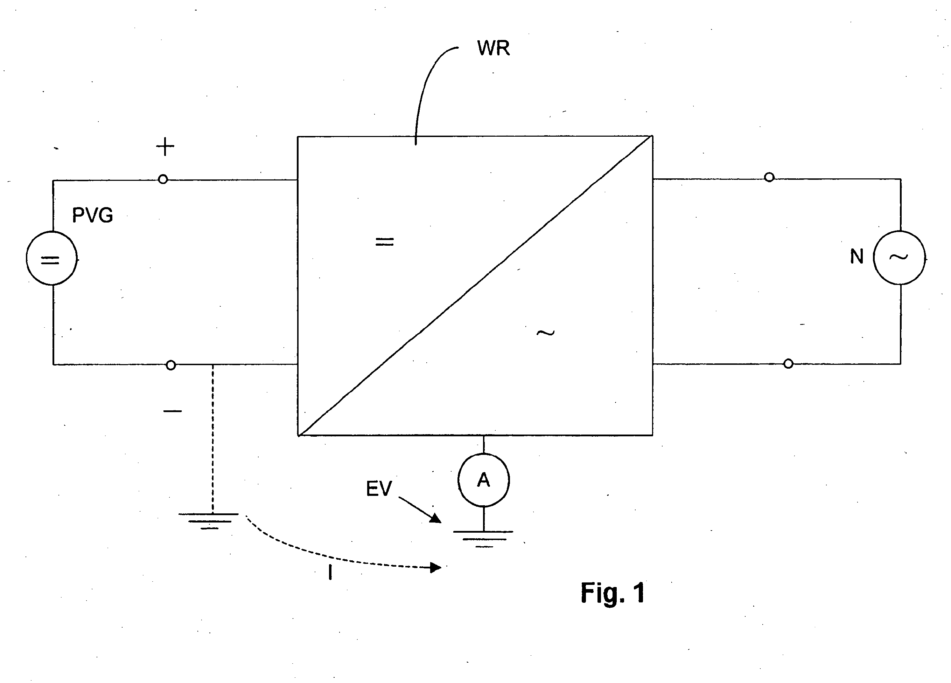

Fig. 1 zeigt einen Wechselrichter WR zur Einspeisung einer Leistung einer Gleichspannungsquelle, insbesondere eines Photovoltaikgenerators PVG in ein Wechselspannungsnetz N. Der Photovoltaikgenerator PVG umfasst Photovoltaikmodule aus amorphen oder kristallinen Zellen. Diese können eine Erdung des Photovoltaikgenerators am Pluspol oder am Minuspol erfordern. Im gezeigten Beispiel ist der Generator mit seinem Minuspol der Erde zugeordnet. Das Wechselspannungsnetz N kann ein Energieversorgungsnetz oder ein Inselnetz sein.

Der Wechselrichter ist über eine Erdungsvorrichtung EV mit Erde verbunden.

Wie in Fig. 1 durch die gestrichelte Linie angedeutet ist, kann am Minuspol des Generators PVG ein zusätzlicher Erdschluss vorliegen. Damit kann ein Strom I von dem zusätzlichen Erdschluss über die Erde zur Erdungsvorrichtung EV fließen. Dieser Strom fließt über die Erdungsvorrichtung EV. Zu messen ist dieser Strom, was durch ein Strommessgerät prinziphaft veranschaulicht ist. Die Erdung muss nicht zwangsläufig über den Wechselrichter WR erfolgen. Es kann auch eine andere Erdungsstelle vorhanden sein.

Das nachfolgende Verfahren dient zur Messung des durch das Erdschluss-Sicherungselement der Erdungsvorrichtung EV und des Erdungsanschlusselementes fließenden Stroms I bei dem geerdeten Wechselrichter zur Einspeisung der Leistung des Generators PVG in das Netz N.

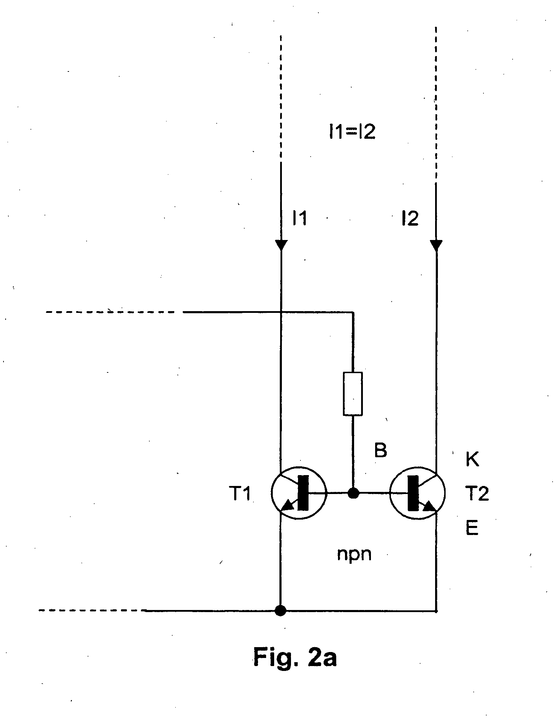

Fig. 2a dient zur Veranschaulichung eines Prinzips eines Stromspiegels. Es sind ein Paar von ansteuerbaren Halbleiterelementen, insbesondere Transistoren T1, T2 an ihrer Basis zusammengeschaltet, wobei beide Transistoren T1, T2 thermisch gekoppelt sind und vom gleichen Typ sind. Beide erhalten damit das gleiche Steuersignal. Jeder Emitteranschluss hat das gleiche Potenzial. Es fließt in beiden Transistoren der gleiche Kollektorstrom I1 = I2.

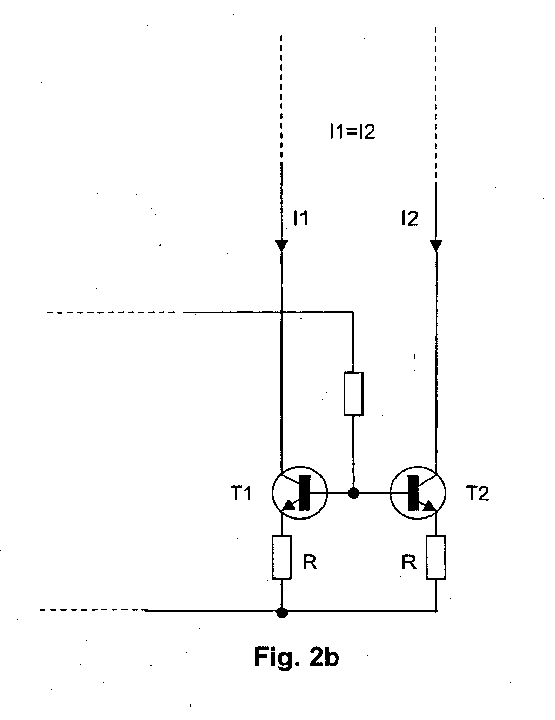

Wie Fig. 2b zeigt, gilt dies auch, wenn zu den Transistoren, hier z.B. zwei npn-Transistoren, jeweils ein Widerstand R gleichen Werts in Reihe geschaltet ist. Diese Schaltung ist immer symmetrisch.

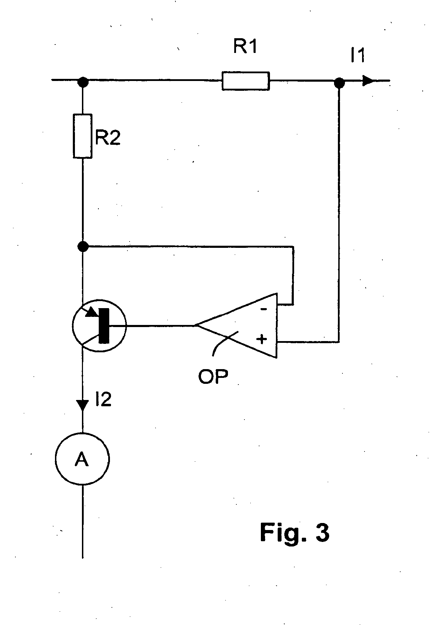

Mit einem Operationsverstärker OP und einem Shunt R1 kann grundsätzlich an einem Strommessgerät ein durch den Shunt R1 fließender Strom gemessen werden, wie Fig. 3 zeigt. In Reihe zum Transistor liegt der Widerstand R2. Es gilt I1 x R1 = I2 x R2. Der durch den Transistor fließende Strom 12 ist proportional zum Strom I1. Es gilt I2 = I1 (R1/R2). Nachteil dieser bekannten Schaltung ist, dass für jede Stromrichtung eine solche Schaltung aufgebaut werden muss. Diese Messelektronik benötigt zudem eine Stromversorgung auf dem Potential der Messstelle.

Daher erfolgt eine Messung mit der Schaltung nach Bild 4a, bei der der Messstrom eine Spannung in einem Shunt Rs einprägt und damit eine Unsymmetrie in einem Stromspiegel nach Fig. 2a bzw. 2b hervorruft. Die Messschaltung umfasst zwei Transistoren T1, T2, hier z.B. zwei pnp-Transistoren mit zwei zwischen Emitter und Shunt angeschlossenen Widerständen R1 = R2. An jedem Kollektor ist ein Widerstand R3 = R4 geschaltet. Zwischen beiden Kollektorwiderständen R3, R4 ist eine Strommesseinrichtung angeordnet. Zur Erzeugung einer Vorspannung für den Stromspiegel wird eine ZenerdiodeZ und ein fünfter Widerstand R5 benutzt.

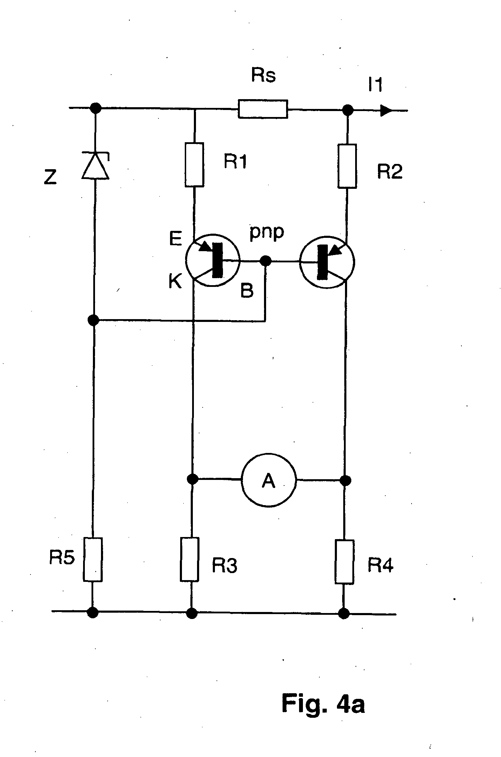

Das Messverfahren beruht darauf, dass der Messstrom über den Shunt Rs geführt wird, um in einem Stromspiegel, wie in Fig. 4a veranschaulicht ist, mit wenigstens zwei an dem Shunt Rs angeschlossenen ansteuerbaren Halbleiterbauelementen T1, T2 eine Asymmetrie zu bewirken, so dass an den Halbleiterbauelementen T1, T2 bzw. deren Kollektorwiderständen eine Spannungsdifferenz entsteht, deren Höhe proportional zum Messstrom I1 ist.

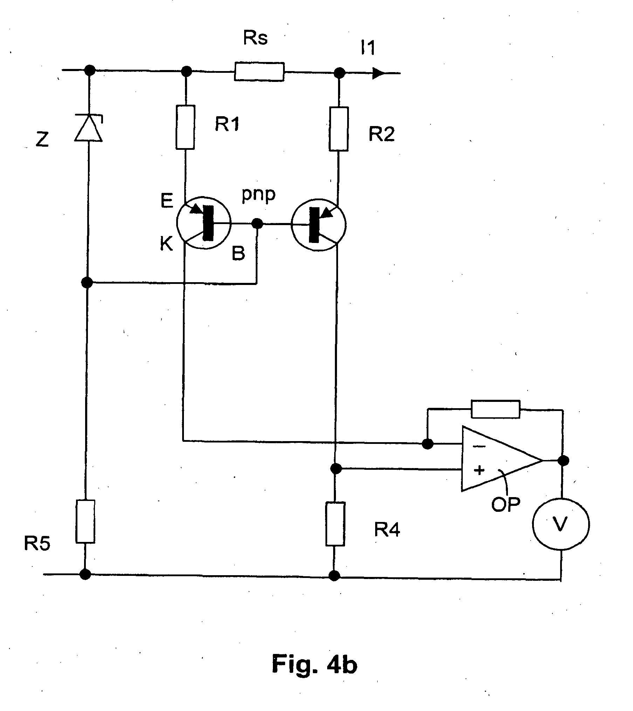

Fig. 4b zeigt eine Erweiterung der Schaltung in Fig. 4a, bei der die Unsymmetrie mit Hilfe einer Operationsverstärkerschaltung ausgewertet wird. Ein Kollektor ist hierbei direkt mit dem invertierenden Operationsverstärkereingang (-) verbunden, während der andere Kollektor mit dem nichtinvertierenden Operationsverstärkereingang (+) verbunden ist. Der Operationsverstärker wird über den Widerstand R3 gegengekoppelt, so dass er als Differenzverstärker für die beiden Kollektorströme des Stromspiegels arbeitet. Die an dem Operationsverstärker OP vorhandene Ausgangsspannung ist dem Strom I1 proportional und kann direkt durch eine Auswerteeinheit, insbesondere einen Mikrocontroller, ausgewertet werden.

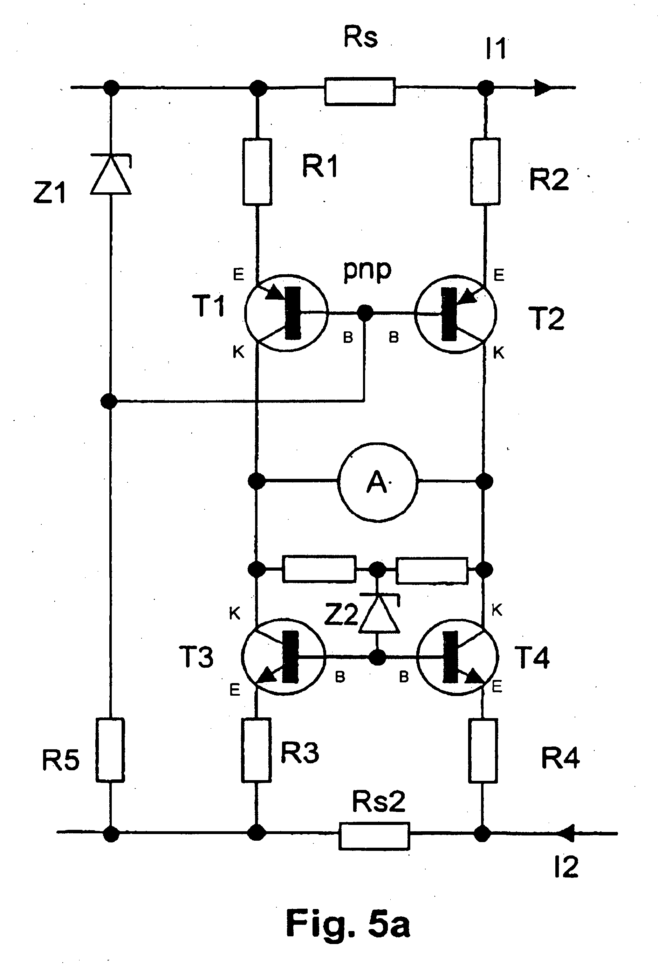

Fig. 5a zeigt das Prinzip einer Strommessung auf zwei verschiedenen Potentialen. Es werden im Grunde zwei der Stromspiegel-Schaltungen kombiniert, indem beide Stromspiegel gegeneinander geschaltet werden. Insgesamt umfasst die Schaltung vier Transistoren T1 bis T4. Die oberen pnp-Transistoren T1, T2 bilden ein erstes Transistorpaar, dem ein erster Shunt Rs an einem Strompfad mit I1 zugeordnet ist. Die unteren pnp-Transistoren T3, T4 bilden ein zweites Transistorpaar, dem ein zweiter Shunt Rs2 am anderen Strompfad mit 12 zugeordnet ist. Zur Vorspannungserzeugung sind die Basen der beiden unteren Transistoren T3, T4 miteinander und mit der Anode einer zweiten Z-Diode Z2 verbunden, deren Kathode über gleiche Widerstände mit den Kollektoren der Transistoren T3 und T4 verbunden ist. Die erste Zenerdiode Z1 ist analog zur Fig. 4a angeschlossen.

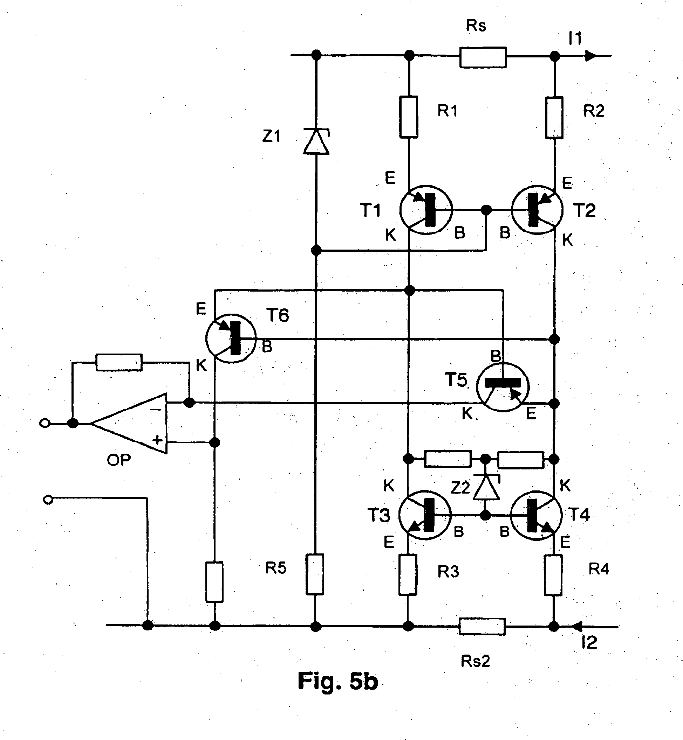

Wie Fig. 5b zeigt, kann auch hier über eine Operationsverstärkerschaltung eine Auswertung erfolgen. Die Operationsverstärkereingänge sind über weitere Transistoren T5 und T6 bzw. Transistorschaltungen mit der Messschaltung verbunden, wie dort gezeigt ist.

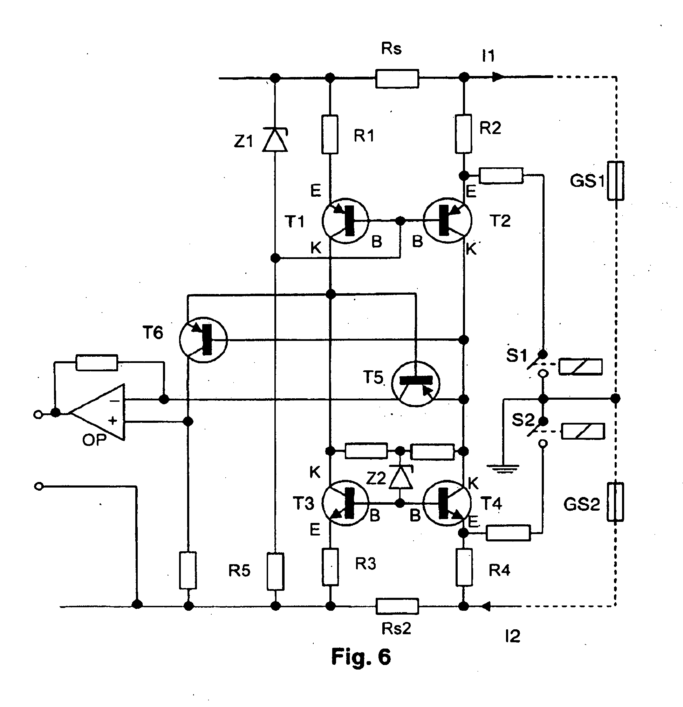

Mit der Schaltung gemäß Fig. 6 kann zusätzlich ein Isolationswiderstand der Stromerzeugungsanlage oder eines damit verbindbaren Geräts bzw. des Wechselrichters WR gemessen werden. Die Anlage ist entweder über die Erdungsvorrichtung GS1 am Pluspol oder über die Erdungsvorrichtung GS2 am Minuspol geerdet oder wird ungeerdet betrieben. Die Erdungsvorrichtungen sind beispielhaft als Schmelzsicherungen dargestellt, wie sie häufig verwendet werden. Bei Erdung am Pluspol entspricht der Erdungsstrom dem Strom I1 und wird über den Stromspiegel aus T1 und T2 erfasst. Bei Erdung am Minuspol entspricht der Erdungsstrom dem Strom I2 und wird über den Stromspiegel aus T3 und T4 erfasst. Wird die Anlage ungeerdet betrieben, kann mit der Schaltung der Isolationswiderstand bestimmt werden. In bekannter Weise dienen zwei Schalter, vorzugsweise Relaisschalter S1, S2, zum Ausführen mehrerer Messungen, um den Widerstand Rᵢₛₒ bei Erdschlüssen an beliebiger Stelle zu bestimmen. Ein derartiges Verfahren ist aus der DE 10 2006 022 686 A1 bekannt und muss nicht näher erläutert werden. Der Stromspiegel wird hier als Stromquelle für die Isolationsmessung bzw. Messung des Widerstandes Rᵢₛₒ benutzt. Da die Ströme über die Schalter S1 und S2, genau wie die Ströme I1 und I2, eine Unsymmetrie in den Stromspiegeln hervorrufen, können sie über den Operationsverstärker bzw. eine daran angeschlossene Auswerteeinheit bestimmt werden. Die Schaltung nach Fig. 6 ermöglicht damit mit einem einzigen Messkanal die Erfassung eines Erdungsstroms wahlweise am Plus- oder Minuspol wie auch die Bestimmung des Isolationswiderstands.

### BEZUGSZEICHENLISTE

- WR: WECHSELRICHTER
- PVG: PHOTOVOLTAIKGENERATOR
- N: Wechselspannungsnetz
- EV: Erdungsvorrichtung
- T1-T6: Transistoren
- R1-R5: Widerstände
- Z1, Z2: Zenerdioden
- GS1, GS2: wahlweise bestückbare Erdungsvorrichtungen, z.B. Sicherungen
- OP: Operationsverstärker
- S1, S2: Relaisschalter
- Rs1, Rs2: Shunts
- Riso: Isolationswiderstand

## Patentansprüche

1. Schaltungsanordnung mit
- einem Wechselrichter (WR) zur Einspeisung einer Leistung eines Photovoltaikgenerators (PVG) in ein Wechselspannungsnetz (N),
- einer Erdungsvorrichtung (GS1, GS2) zum Erden des Photovoltaikgenerators (PVG) alternativ am Pluspol oder am Minuspol,
- einem ersten Shunt (Rs), durch den ein Erdungsstrom bei Erdung am Pluspol fließt, und einem zweiten Shunt (Rs2), durch den der Erdungsstrom bei alternativer Erdung am Minuspol fließt,
- wobei die beiden Shunts (Rs, Rs2) jeweils in einen Stromspiegel eingefügt sind,
- wobei die beiden Stromspiegel jeweils aus einem Paar Transistoren gleicher Polarität bestehen,
- wobei mit jedem Transistor ein Widerstand in Reihe geschaltet ist,
- wobei die Emitteranschlüsse der beiden Transistoren eines Stromspiegels jeweils über gleiche Widerstände mit den beiden Anschlüssen des Shunts verbunden sind,
- wobei beide Basisanschlüsse der beiden Transistoren des Stromspiegels miteinander verbunden und an eine Vorspannung angeschlossen sind und
- wobei die beiden Stromspiegel an einer Auswertestelle gegeneinander geschaltet sind, indem jeweils ein Kollektoranschluss des einen Stromspiegels mit einem Kollektoranschluss des anderen Stromspiegels mittels einer Auswerteeinheit verbunden ist,
- wobei der durch den Erdungsstrom durch den jeweiligen Shunt verursachte Spannungsabfall eine Asymmetrie in dem zugehörigen Stromspiegel hervorruft, deren Höhe proportional zu dem Erdungsstrom ist, und
- wobei die Asymmetrie an der Auswertestelle ausgewertet wird, an der die beiden Stromspiegel gegeneinander geschaltet sind, indem an der Auswertestelle zwischen den beiden Verbindungspunkten ein Differenzstrom ermittelt und von der Auswerteeinheit ausgewertet wird, und
- wobei das Potenzial der Auswertestelle von dem Potenzial, auf dem der jeweilige Erdungsstrom fließt, erheblich abweicht.

2. Schaltungsanordnung nach Anspruch 1, **gekennzeichnet durch** Zenerdioden (Z1, Z2), die zur Erzeugung der jeweiligen Vorspannung an die miteinander verbundenen Basisanschlüsse der Transistoren eines der Stromspiegel angeschlossen sind.

3. Schaltungsanordnung nach einem der Ansprüche 1 und 2, **dadurch gekennzeichnet, dass** die beiden Verbindungspunkte durch antiparallel geschaltete Basis-Emitter-Strecken zweier Transistoren verbunden werden, deren Kollektorströme von der Auswerteeinheit ausgewertet werden.

4. Schaltungsanordnung mit
- einem Wechselrichter (WR) zur Einspeisung einer Leistung eines Photovoltaikgenerators (PVG) in ein Wechselspannungsnetz (N),
- einer Erdungsvorrichtung (GS1, GS2) zum Erden des Photovoltaikgenerators (PVG) alternativ am Pluspol oder am Minuspol,
- einem ersten Shunt (Rs), durch den ein Erdungsstrom bei Erdung am Pluspol fließt, und einem zweiten Shunt (Rs2), durch den der Erdungsstrom bei alternativer Erdung am Minuspol fließt,
- wobei die beiden Shunts (Rs, Rs2) jeweils in einen Stromspiegel eingefügt sind,
- wobei die beiden Stromspiegel jeweils aus einem Paar Transistoren gleicher Polarität bestehen,
- wobei mit jedem Transistor ein Widerstand in Reihe geschaltet ist,
- wobei die Sourceanschlüsse der beiden Transistoren eines Stromspiegels jeweils über gleiche Widerstände mit den beiden Anschlüssen des Shunts verbunden sind,
- wobei beide Gateanschlüsse der beiden Transistoren des Stromspiegels miteinander verbunden und an eine Vorspannung angeschlossen sind,
- wobei die beiden Stromspiegel an einer Auswertestelle gegeneinander geschaltet sind, indem jeweils ein Drainanschluss des einen Stromspiegels mit einem Drainanschluss des anderen Stromspiegels mittels einer Auswerteeinheit verbunden ist,
- wobei der durch den Erdungsstrom durch den jeweiligen Shunt verursachte Spannungsabfall eine Asymmetrie in dem zugehörigen Stromspiegel hervorruft, deren Höhe proportional zu dem Erdungsstrom ist, und
- wobei die Asymmetrie an der Auswertestelle ausgewertet wird, an der die beiden Stromspiegel gegeneinander geschaltet sind, indem an der Auswertestelle zwischen den beiden Verbindungspunkten ein Differenzstrom ermittelt und von der Auswerteeinheit ausgewertet wird, und
- wobei das Potenzial der Auswertestelle von dem Potenzial, auf dem der jeweilige Erdungsstrom fließt, erheblich abweicht.

5. Schaltungsanordnung nach Anspruch 4, **gekennzeichnet durch** Zenerdioden (Z1, Z2), die zur Erzeugung der jeweiligenVorspannung an die miteinander verbundenen Gateanschlüsse der Transistoren eines der Stromspiegel angeschlossen sind.

6. Schaltungsanordnung nach einem der Ansprüche 1 bis 5, **dadurch gekennzeichnet, dass** die Auswerteeinheit mittels eines Operationsverstärkers (OP) an die Auswertestelle angeschlossen ist, wobei der Operationsverstärker (OP) über weitere Transistoren (T5, T6) mit den beiden Verbindungspunkten der Stromspiegel verbunden ist.

7. Schaltungsanordnung nach einem der Ansprüche 1 bis 6, **dadurch gekennzeichnet,**
- **dass** zwei Schaltelemente vorhanden sind, die direkt oder in Reihe mit einem strombegrenzenden Element eine Verbindung zwischen Erde und einem Emitter- bzw. Sourceanschluss eines der Transistoren jeweils eines Stromspiegels herstellen,
- **dass** beim Schliessen eines der beiden Schaltelemente jeweils eine Unsymmetrie in einem der beiden Stromspiegel erzeugt wird, die durch die Auswerteeinheit ausgewertet wird, und
- **dass** die beiden Schaltelemente benutzt werden, um mit Hilfe der Auswerteeinheit eine Isolationswiderstandsmessung durchzuführen.

## Claims

1. Circuit arrangement comprising
- an inverter (WR) for feeding a power from a photovoltaic generator (PVG) into an AC voltage grid (N),
- a grounding device (GS1, GS2) for grounding the photovoltaic generator (PVG) either at the positive terminal or at the negative terminal,
- a first shunt (Rs), through which a grounding current flows on grounding at the positive terminal, and a second shunt (Rs2), through which the grounding current flows on alternative grounding at the negative terminal,
- wherein the two shunts (Rs, Rs2) are each inserted into a corresponding current mirror,
- wherein the two current mirrors each consist of a pair of transistors of the same polarity,
- wherein a resistor is connected in series with each transistor,
- wherein the emitter connections of the two transistors of a current mirror are each connected via identical resistors to the two connections of the shunt,
- wherein the two base connections of the two transistors of the current mirror are connected to one another and connected to a bias, and
- wherein the two current mirrors are connected in opposition to one another at an evaluation point by connecting one collector connection of one current mirror to a collector connection of the other current mirror by means of an evaluation unit,
- wherein the voltage drop caused by the grounding current through the respective shunt causes an asymmetry in the associated current mirror with a level proportional to the grounding current, and
- wherein the asymmetry is evaluated at the evaluation point, at which the two current mirrors are connected in opposition to one another, by determining a differential current between the two nodes at the evaluation point and evaluating by the evaluation unit, and
- wherein the potential of the evaluation point deviates considerably from the potential at which the respective grounding current flows.

2. Circuit arrangement according to Claim 1, **characterized by** Zener diodes (Z1, Z2), which are connected to the mutually interconnected base connections of the transistors of one of the current mirrors in order to generate the respective bias.

3. Circuit arrangement according to Claims 1 or 2, **characterized in that** the two nodes are connected by base-emitter paths of two transistors, which paths are connected back-to-back in parallel with one another, the collector currents thereof being evaluated by the evaluation unit.

4. Circuit arrangement comprising
- an inverter (WR) for feeding a power from a photovoltaic generator (PVG) into an AC voltage grid (N),
- a grounding device (GS1, GS2) for grounding the photovoltaic generator (PVG) either at the positive terminal or at the negative terminal,
- a first shunt (Rs), through which a grounding current flows on grounding at the positive terminal, and a second shunt (Rs2), through which the grounding current flows on alternative grounding at the negative terminal,
- wherein the two shunts (Rs, Rs2) are each inserted into a corresponding current mirror,
- wherein the two current mirrors each consist of a pair of transistors of the same polarity,
- wherein a resistor is connected in series with each transistor,
- wherein the source connections of the two transistors of a current mirror are each connected via identical resistors to the two connections of the shunt,
- wherein the two gate connections of the two transistors of the current mirror are connected to one another and connected to a bias,
- wherein the two current mirrors are connected in opposition to one another at an evaluation point by connecting one drain connection of one current mirror to a drain connection of the other current mirror by means of an evaluation unit,
- wherein the voltage drop caused by the grounding current through the respective shunt causes an asymmetry in the associated current mirror with a level proportional to the grounding current, and
- wherein the asymmetry is evaluated at the evaluation point, at which the two current mirrors are connected in opposition to one another, by determining a differential current at the evaluation point between the two nodes and being evaluated by the evaluation unit, and
- wherein the potential of the evaluation point deviates considerably from the potential at which the respective grounding current flows.

5. Circuit arrangement according to Claim 4, **characterized by** Zener diodes (Z1, Z2), which are connected to the mutually interconnected gate connections of the transistors of one of the current mirrors in order to generate the respective bias.

6. Circuit arrangement according to one of Claims 1 to 5, **characterized in that** the evaluation unit is connected to the evaluation point by means of an operational amplifier (OP), wherein the operational amplifier (OP) is connected to the two nodes of the current mirrors via further transistors (T5, T6).

7. Circuit arrangement according to one of Claims 1 to 6, **characterized**
- **in that** two switching elements are provided, which produce, directly or in series with a current-limiting element, a connection between earth and an emitter or source connection of one of the transistors of in each case one current mirror,
- **in that**, on closing of one of the two switching elements, in each case, an asymmetry is generated in one of the two current mirrors, which is evaluated by the evaluation unit, and
- **in that** the two switching elements are used to perform a dielectric resistance measurement with the aid of the evaluation unit.

## Revendications

1. Agencement de circuit avec :
- un ondulateur (WR) permettant d'emmagasiner la puissance d'un générateur photovoltaïque (PVG) dans un réseau de tension alternative (N) ;
- un dispositif de mise à la terre (GS1, GS2) pour mettre à la terre le générateur photovoltaïque (PVG) en alternance au pôle positif ou au pôle négatif ;
- un premier shunt (Rs) à travers lequel un courant de mise à la terre circule lors de la mise à la terre avec le pôle positif et un deuxième shunt (Rs2) à travers lequel le courant de mise à la terre circule lors de la mise à la terre alternative avec le pôle négatif ;
- les deux shunts (Rs, Rs2) étant insérés dans un miroir de courant respective;
- les deux miroirs de courant se composant respectivement d'une paire de transistors de même polarité ;
- une résistance connectée en série à chaque transistor ;
- les bornes d'émetteur des deux transistors d'un miroir de courant étant respectivement reliées, via les mêmes résistances, aux deux bornes du shunt ;
- les deux bornes de base des deux transistors du miroir de courant étant reliées entre elles et étant raccordées à une prétension ; et
- les deux miroirs de courant étant connectés l'un contre l'autre au point d'analyse en reliant respectivement une borne de collecteur du premier miroir de courant à une borne de collecteur de l'autre miroir de courant au moyen d'une unité d'analyse ;
- la chute de tension provoquée par le courant de mise à la terre passant par le shunt respectif provoquant une asymétrie dans le miroir de courant associé dont la hauteur est proportionnelle au courant de mise à la terre ; et
- l'asymétrie est analysée au point d'analyse au niveau duquel les deux miroirs de courant sont connectés l'un contre l'autre en calculant un courant différentiel au point d'analyse situé entre les deux points de liaison et en l'analysant avec une unité d'analyse ; et
- le potentiel du point d'analyse s'écartant de façon considérable du potentiel sur lequel le courant de mise à la terre respectif circule.

2. Agencement de circuit selon la revendication 1, **caractérisé par** la présence de diodes de Zener (Z1, Z2) raccordées aux bornes de base, reliées entre elles, des transistors d'un des miroirs de courant pour produire la prétension respective.

3. Agencement de circuit selon l'une quelconque des revendications 1 et 2, **caractérisé en ce que** les deux points de liaison sont reliés par des tronçons d'émetteur de base, connectés antiparallèlement, de deux transistors dont les courants de collecteur sont analysés par l'unité d'analyse.

4. Agencement de circuit avec :
- un ondulateur (WR) permettant d'emmagasiner la puissance d'un générateur photovoltaïque (PVG) dans un réseau de tension alternative (N) ;
- un dispositif de mise à la terre (GS1, GS2) pour mettre à la terre le générateur photovoltaïque (PVG) en alternance au pôle positif ou au pôle négatif ;
- un premier shunt (Rs) à travers lequel un courant de mise à la terre circule lors de la mise à la terre avec le pôle positif et un deuxième shunt (Rs2) à travers lequel le courant de mise à la terre circule lors de la mise à la terre alternative avec le pôle négatif ;
- les deux shunts (Rs, Rs2) étant insérés dans un miroir de courant respective;
- les deux miroirs de courant se composant respectivement d'une paire de transistors de même polarité ;
- une résistance connectée en série à chaque transistor ;
- les bornes de source des deux transistors d'un miroir de courant étant respectivement reliées, via les mêmes résistances, aux deux bornes du shunt ;
- les deux bornes de grille des deux transistors du miroir de courant étant reliées entre elles et étant raccordées à une prétension ; et
- les deux miroirs de courant étant connectés l'un contre l'autre au point d'analyse en reliant respectivement une borne de drain du premier miroir de courant à une borne de drain de l'autre miroir de courant au moyen d'une unité d'analyse ;
- la chute de tension provoquée par le courant de mise à la terre passant par le shunt respectif provoquant une asymétrie dans le miroir de courant associé dont la hauteur est proportionnelle au courant de mise à la terre ; et
- l'asymétrie est analysée au point d'analyse au niveau duquel les deux miroirs de courant sont connectés l'un contre l'autre en calculant un courant différentiel au point d'analyse situé entre les deux points de liaison et en l'analysant avec une unité d'analyse ; et
- le potentiel du point d'analyse s'écartant de façon considérable du potentiel sur lequel le courant de mise à la terre respectif circule.

5. Agencement de circuit selon la revendication 4, **caractérisé par** la présence de diodes de Zener (Z1, Z2) raccordées aux bornes de grille, reliées entre elles, des transistors d'un des miroirs de courant pour produire la prétension respective.

6. Agencement de circuit selon l'une quelconque des revendications 1 à 5, **caractérisé en ce que** l'unité d'analyse est raccordée au point d'analyse à l'aide d'un amplificateur opérationnel (OP), l'amplificateur opérationnel (OP) étant relié aux deux points de liaison des miroirs de courant via des transistors (T5, T6) supplémentaires.

7. Agencement de circuit selon l'une quelconque des revendications 1 à 6, **caractérisé en ce que** :
- deux éléments de commutation sont présents établissant une liaison entre la terre et une borne d'émetteur et/ou de source d'un des transistors d'un miroir de courant respectif, directement ou en série avec un élément limitant le courant ;
- une dissymétrie respectivement produite dans un des deux miroirs de courant lors de la fermeture d'un des deux éléments de commutation est analysée par l'unité d'analyse ; et
- les deux éléments de commutation sont utilisés pour effectuer une mesure de résistance d'isolation à l'aide de l'unité d'analyse.
